(19) Europäisches Patentamt / European Patent Office / Office européen des brevets

(11) **EP 3 123 246 B1**

(12) **EUROPÄISCHE PATENTSCHRIFT**

(45) Veröffentlichungstag und Bekanntmachung des Hinweises auf die Patenterteilung:
**22.08.2018 Patentblatt 2018/34**

(21) Anmeldenummer: **15711062.8**

(22) Anmeldetag: **27.02.2015**

(51) Int Cl.:
*G03F 7/20* (2006.01)          *G21K 1/06* (2006.01)
*H01S 3/09* (2006.01)          *H05H 7/04* (2006.01)
*H05G 2/00* (2006.01)

(86) Internationale Anmeldenummer:
**PCT/EP2015/054175**

(87) Internationale Veröffentlichungsnummer:
**WO 2015/144386 (01.10.2015 Gazette 2015/39)**

(54) **EUV-LICHTQUELLE FÜR EINE BELEUCHTUNGSEINRICHTUNG EINER MIKROLITHOGRAPHISCHEN PROJEKTIONSBELICHTUNGSANLAGE**

EUV LIGHT SOURCE FOR A LIGHTING DEVICE OF A MICROLITHOGRAPHIC PROJECTION EXPOSURE APPARATUS

SOURCE DE LUMIÈRE EUV DESTINÉE À UN DISPOSITIF D'ÉCLAIRAGE D'UNE INSTALLATION MICROLITHOGRAPHIQUE D'ILLUMINATION PAR PROJECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.03.2014 DE 102014205579**

(43) Veröffentlichungstag der Anmeldung:
**01.02.2017 Patentblatt 2017/05**

(73) Patentinhaber: **Carl Zeiss SMT GmbH**
**73447 Oberkochen (DE)**

(72) Erfinder: **PATRA, Michael**
**73447 Oberkochen (DE)**

(74) Vertreter: **Frank, Hartmut**
**Bonsmann Bonsmann Frank**
**Patentanwälte**
**Reichspräsidentenstraße 21-25**
**45470 Mülheim a. d. Ruhr (DE)**

(56) Entgegenhaltungen:
- **GENG H ET AL: "Crossed undulator polarization control for X-ray FELs in the saturation regime", NUCLEAR INSTRUMENTS & METHODS IN PHYSICS RESEARCH, SECTION A (ACCELERATORS, SPECTROMETERS, DETECTORS AND ASSOCIATED EQUIPMENT) ELSEVIER SCIENCE B.V. NETHERLANDS, Bd. 622, Nr. 1, 1. Oktober 2010 (2010-10-01), Seiten 276-280, XP002742388, ISSN: 0168-9002**
- **KWANG-JE KIM: "Circular polarization with crossed-planar undulators in high-gain FELs", NUCLEAR INSTRUMENTS & METHODS IN PHYSICS RESEARCH, SECTION A (ACCELERATORS, SPECTROMETERS, DETECTORS AND ASSOCIATED EQUIPMENT) ELSEVIER NETHERLANDS, Bd. 445, Nr. 1-3, 1. Mai 2000 (2000-05-01), Seiten 329-332, XP002742389, ISSN: 0168-9002**
- **NEWNAM B E ED - DRIGGERS RONALD G: "EXTREME ULTRAVIOLET FREE-ELECTRON LASER-BASED PROJECTION LITHOGRAPHY SYSTEMS", OPTICAL ENGINEERING, SOC. OF PHOTO-OPTICAL INSTRUMENTATION ENGINEERS, BELLINGHAM, Bd. 30, Nr. 8, 1. August 1991 (1991-08-01), Seiten 1100-1108, XP000222831, ISSN: 0091-3286, DOI: 10.1117/12.55914**

**Beschreibung**

Die vorliegende Anmeldung beansprucht die Priorität der Deutschen Patentanmeldung DE 10 2014 205 579.2, angemeldet am 26. März 2014.

HINTERGRUND DER ERFINDUNG

Gebiet der Erfindung

Die Erfindung betrifft eine EUV-Lichtquelle für eine Beleuchtungseinrichtung einer mikrolithographischen Projektionsbelichtungsanlage.

Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet.

Als EUV-Strahlungsquelle ist außer Plasmaquellen und Synchrotrons der Einsatz von Freie-Elektronen-Laser bekannt. Diese haben u.a. den Vorteil, dass die erzeugte Strahlung auf die gewünschte EUV-Strahlung, d.h. den gewünschten Wellenlängenbereich, beschränkt ist und auch die bei Plasmaquellen infolge der dort benötigten Targetmaterialien entstehenden Kontaminationen vermieden werden.

Im Betrieb einer Projektionsbelichtungsanlage besteht ein Bedarf, in der Beleuchtungseinrichtung zur Optimierung des Abbildungskontrastes gezielt bestimmte Polarisationsverteilungen in der Pupillenebene und/oder im Retikel einzustellen sowie auch eine Änderung der Polarisationsverteilung im Betrieb der Projektionsbelichtungsanlage vornehmen zu können.

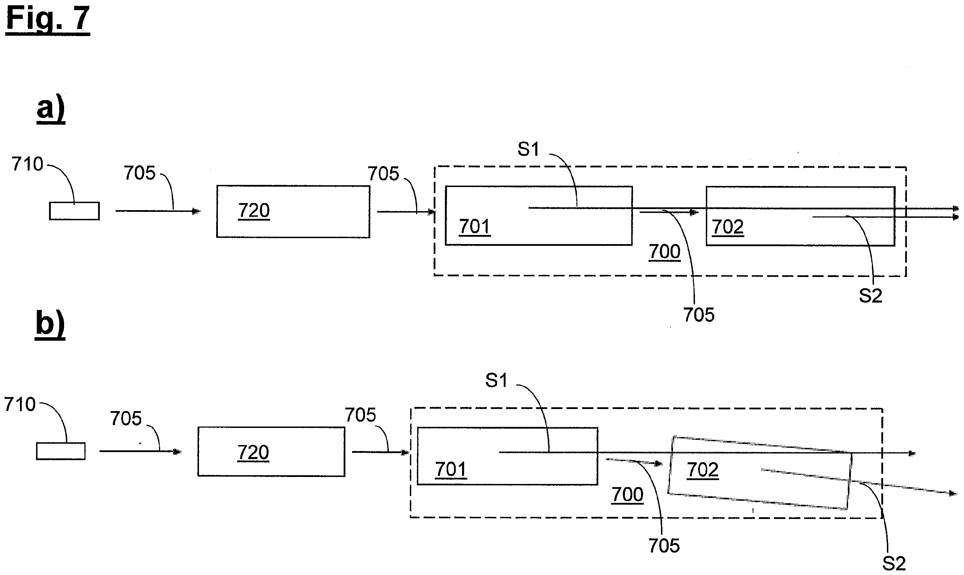

Grundsätzlich erfolgt in einem Freie-Elektronen-Laser die Erzeugung polarisierter Strahlung durch Verwendung einer Undulator-Anordnung, welche eine Mehrzahl von Magneten zur Erzeugung von EUV-Licht durch Ablenkung des Elektronenstrahls aufweist. Fig. 7a und Fig. 7b zeigen jeweils einen möglichen Aufbau eines Freie-Elektronen-Lasers, welcher eine Elektronenquelle 710 zum Erzeugen eines Elektronenstrahls 705, eine Beschleuniger-Einheit 720 zum Beschleunigen dieses Elektronenstrahls 705 sowie eine Undulator-Anordnung 700 mit einer Mehrzahl von Magneten zur Erzeugung von EUV-Licht durch Ablenkung des Elektronenstrahls 705 aufweist, wobei diese Undulator-Anordnung 700 hier zwei Undulatoren 701, 702 aufweist. Da die Polarisation der erzeugten Strahlung durch die konkrete Anordnung der Magneten der Undulator-Anordnung 700 vorgegeben wird, lassen sich prinzipiell gemäß Fig. 7a,b bei Verwendung einer Undulator-Anordnung 700 mit zwei Undulatoren 701, 702 Lichtstrahlen S1, S2 mit voneinander verschiedener Polarisationsrichtung (z.B. horizontal und vertikal polarisiertes Licht) erzeugen, wobei wie in Fig. 7b angedeutet auch eine räumliche Trennung der jeweiligen Strahlengänge z.B. durch Verkippung der Undulatoren 701, 702 gegeneinander (bezogen auf die jeweilige Ausbreitungsrichtung des Elektronenstrahls innerhalb des betreffenden Undulators) realisierbar ist.

Wenngleich das vorstehend anhand von Fig. 7a,b beschriebene Prinzip grundsätzlich die Einstellung unterschiedlicher polarisierter Beleuchtungssettings (einschließlich der Erzeugung von effektiv unpolarisierter Strahlung bei Überlagerung von horizontal und vertikal polarisiertem Licht) erlaubt, tritt hierbei in der Praxis das Problem auf, dass je nach gewünschtem polarisierter Beleuchtungssettings das Licht des Undulators mit dem jeweils nicht erwünschten Polarisationszustand nicht genutzt wird bzw. verloren geht, wodurch die Leistungsfähigkeit der Projektionsbelichtungsanlage beeinträchtigt wird.

Zum Stand der Technik hinsichtlich der Änderung der Polarisationsverteilung in für den EUV-Bereich ausgelegten Projektionsbelichtungsanlagen wird lediglich beispielhaft auf DE 10 2008 002 749 A1, US 2008/0192225 A1, WO 2006/111319 A2 und US 6,999,172 B2 verwiesen. Geng et al., Nuclear Instruments and Methods A 622 (2010) 276-280 offenbart eine FEL-Röntgen Lichtquelle mit zwei Undulatoren. Newnam, Optical Engineering 30 (1991) 1100-1108 offenbart die Verwendung von mehreren unabhängigen FEL-EUV Lichtquellen für eine mikrolithographische Projektionsbelichtungsanlage.

ZUSAMMENFASSUNG DER ERFINDUNG

Es ist eine Aufgabe der vorliegenden Erfindung, eine EUV-Lichtquelle für eine Beleuchtungseinrichtung einer mikrolithographischen Projektionsbelichtungsanlage bereitzustellen, welche eine flexible Einstellung der Polarisationsverteilung in der Projektionsbelichtungsanlage bei vergleichsweise geringem Lichtverlust ermöglicht.

Diese Aufgabe wird gemäß den Merkmalen des unabhängigen Patentanspruchs 1 gelöst.

Eine erfindungsgemäße Lichtquelle für eine Beleuchtungseinrichtung einer mikrolithographischen Projektionsbelichtungsanlage weist eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls auf, wobei diese Undulator-Anordnung aufweist:

- einen ersten Undulator zur Erzeugung von EUV-Licht mit einem ersten Polarisationszustand; und

- wenigstens einen zweiten Undulator zur Erzeugung von EUV-Licht mit einem zweiten Polarisationszustand, wobei der zweite Polarisationszustand von dem ersten Polarisationszustand verschieden ist;

- wobei der zweite Undulator entlang der Ausbreitungsrichtung des Elektronenstrahls nach dem ersten Undulator angeordnet ist; und

- wobei die Undulator-Anordnung derart konfiguriert ist, dass diese einen ersten Betriebsmodus, in welchem sich der erste Undulator hinsichtlich der Erzeugung von EUV-Licht in Sättigung befindet, und wenigstens einen zweiten Betriebsmodus aufweist, in welchem sich der erste Undulator hinsichtlich der Erzeugung von EUV-Licht nicht in Sättigung befindet.

Der vorliegenden Erfindung liegt insbesondere das Konzept zugrunde, die flexible Einstellung unterschiedlicher gewünschter polarisierter Beleuchtungssettings dadurch zu realisieren, dass eine Variation der jeweiligen Beträge der in der erfindungsgemäßen Undulator-Anordnung vorhandenen beiden Undulatoren zur insgesamt erzeugten elektromagnetischen Strahlung und damit eine flexible Einstellung des letztlich erzeugten Polarisationszustandes erzielt wird.

Dadurch, dass der entlang der Ausbreitungsrichtung des Elektronenstrahls erste Undulator selektiv entweder in Sättigung oder auch nicht in Sättigung betrieben wird, gelingt es gemäß der Erfindung zugleich, denjenigen Anteil zu variieren, den der bezogen auf die Ausbreitungsrichtung des Elektronenstrahls zweite Undulator an der insgesamt von der Undulator-Anordnung freigesetzten Strahlung hat. Dem liegt die Überlegung zugrunde, dass im Falle des Eintritts der Sättigung im ersten Undulator die gesamte nutzbare Energie bereits im ersten Undulator aus dem Elektronenstrahl entnommen wird mit der Folge, dass bei Durchlaufen des zweiten Undulators die Energieunschärfe der Elektronen bereits so groß ist, dass dort keine Laseraktion mehr möglich ist. Wird hingegen bei nicht im ersten Undulator eintretender Sättigung durch den ersten Undulator vergleichsweise wenig Licht erzeugt bzw. Energie aus dem Elektronenstrahl entnommen, findet die Laseraktion bzw. Lichterzeugung entsprechend in dem zweiten Undulator statt.

Im Ergebnis kann so unter fortwährender Nutzung der gesamten, durch die erfindungsgemäße Undulator-Anordnung freigesetzten Strahlungsenergie bzw. -intensität im Wege der Variation der relativen Beiträge der beiden Undulatoren zu dieser Gesamtintensität die flexible Einstellung der Polarisationsverteilung ohne signifikanten Lichtverlust erreicht werden.

Dabei besteht ein weiterer Vorteil der Erfindung darin, dass das erfindungsgemäße Konzept unter Einsatz von zwei Undulatoren zu keiner signifikanten Erhöhung des Kostenaufwands führt, da der wesentliche Kostenaufwand in einem Freie-Elektronen-Laser durch die Komponenten zur Beschleunigung der Elektronen sowie die erforderliche Kühlung dieser Komponenten (und nicht durch die Undulator-Anordnung) verursacht wird.

Ein weiterer Vorteil der Erfindung besteht darin, dass - wie im Weiteren noch näher erläutert - eine signifikante Variation der Verteilung der insgesamt abgestrahlten Energie auf die beiden Undulatoren und damit des letztlich bereitgestellten Polarisationszustandes bereits mit einer vergleichsweise geringen Änderung der sogenannten Gainlänge bzw. hierfür relevanter Parameter erreicht werden kann.

Darunter, dass ein Undulator sich hinsichtlich der Erzeugung von EUV-Licht in Sättigung befindet, wird im Sinne der vorliegenden Offenbarung vorzugsweise verstanden, dass die Intensität am Ausgang des betreffenden Undulators weniger ist als das 1.1-fache desjenigen Intensitätswertes ist, der nach 90%-igem Durchlauf des betreffenden Undulators erreicht ist (wobei von einer Intensität am Ausgang des betreffenden Undulators ungleich Null ausgegangen wird).

Die Undulator-Anordnung kann zur Erzeugung von EUV-Licht eine Mehrzahl von Magneten aufweisen. Die Erfindung ist jedoch nicht hierauf beschränkt, wobei in weiteren Ausführungsformen auch das elektromagnetische Feld eines Lasers verwendet werden kann, wie z.B. aus US 2007/0152171 A1 bekannt.

Gemäß einer Ausführungsform ist die Undulator-Anordnung derart konfiguriert, dass in wenigstens einem Betriebsmodus die Erzeugung des EUV-Lichtes zu einem Anteil von wenigstens 90% durch den zweiten Undulator erfolgt.

Gemäß einer Ausführungsform ist die Undulator-Anordnung derart konfiguriert, dass in wenigstens einem Betriebsmodus die Erzeugung des EUV-Lichtes zu einem Anteil von wenigstens 90% durch den ersten Undulator erfolgt.

Gemäß einer Ausführungsform ist die Undulator-Anordnung derart konfiguriert, dass in wenigstens einem Betriebsmodus die Erzeugung des EUV-Lichtes zu einem Anteil von wenigstens 40% durch den ersten Undulator sowie zu einem Anteil von wenigstens 40% durch den zweiten Undulator erfolgt.

Gemäß einer Ausführungsform ist der Polarisationszustand des durch die Undulator-Anordnung erzeugten EUV-Lichtes durch Modifikation des Elektronenstrahls vor dessen Eintritt in die Undulator-Anordnung variabel einstellbar. Insbesondere kann der Polarisationszustand des durch die Undulator-Anordnung erzeugten EUV-Lichtes durch Modifikation der Gainlänge des Elektronenstrahls vor dessen Eintritt in die Undulator-Anordnung variabel einstellbar sein. Dadurch, dass die Polarisationseinstellung (bzw. die Variation der relativen Beiträge der beiden Undulatoren) durch Einstellung bzw. Modifikation des Elektronenstrahls vor dessen Eintritt in die Undulator-Anordnung erfolgt, ist keine Aktuierung innerhalb der Undulator-Anordnung selbst erforderlich, so dass ein mit einer solchen Aktuierung der Undulator-Anordnung verbundener konstruktiver Aufwand vermieden wird.

Gemäß einer Ausführungsform weist die EUV-Lichtquelle eine Mehrzahl von mit elektrischem Strom beaufschlagbaren Quadrupolmagneten zur Fokussierung des Elektronenstrahls auf, wobei das Umschalten zwischen dem ersten Betriebsmodus und dem zweiten Betriebsmodus zumindest teilweise durch Variation des elektrischen Stroms in wenigstens einem dieser Quadrupolmagnete erfolgt.

Gemäß einer Ausführungsform sind der erste Polarisationszustand und der zweite Polarisationszustand zueinander orthogonal.

Gemäß einer Ausführungsform ist die Undulator-Anordnung weiter derart konfiguriert, dass ein von dem ersten Undulator erzeugter erster Lichtstrahl und ein von dem zweiten Undulator erzeugter zweiter Lichtstrahl der Beleuchtungseinrichtung voneinander räumlich getrennt zuführbar sind.

Gemäß einer Ausführungsform sind der erste Undulator und der zweite Undulator derart angeordnet, dass die Ausbreitungsrichtung des Elektronenstrahls in dem ersten Undulator und die Ausbreitungsrichtung des Elektronenstrahls in dem zweiten Undulator zueinander verkippt sind.

Gemäß einer Ausführungsform ist die Undulator-Anordnung derart konfiguriert, dass ein von dem ersten Undulator erzeugter erster Lichtstrahl und ein von dem zweiten Undulator erzeugter zweiter Lichtstrahl bei Zuführung zu der Beleuchtungseinrichtung einander überlagerbar sind.

Die Erfindung betrifft weiter eine mikrolithographische Projektionsbelichtungsanlage mit einer Beleuchtungseinrichtung und einem Projektionsobjektiv, wobei die Projektionsbelichtungsanlage eine EUV-Lichtquelle mit den vorstehenden Merkmalen aufweist.

Gemäß einem weiteren Aspekt betrifft die Erfindung eine mikrolithographische Projektionsbelichtungsanlage mit einer EUV-Lichtquelle, einer Beleuchtungseinrichtung und einem Projektionsobjektiv, wobei die EUV-Lichtquelle eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls aufweist,

- wobei diese Undulator-Anordnung einen ersten Undulator zur Erzeugung von EUV-Licht mit einem ersten Polarisationszustand und wenigstens einen zweiten Undulator zur Erzeugung von EUV-Licht mit einem zweiten Polarisationszustand aufweist, wobei der zweite Polarisationszustand von dem ersten Polarisationszustand verschieden ist;

- wobei im Betrieb der Projektionsbelichtungsanlage von ersten Undulator erzeugtes EUV-Licht und von dem zweiten Undulator erzeugtes EUV-Licht jeweils in die Beleuchtungseinrichtung eingekoppelt wird; und

- wobei der jeweilige relative Anteil, zu dem die Energie des Elektronenstrahls in von dem ersten Undulator erzeugtes EUV-Licht bzw. in von dem zweiten Undulator erzeugtes EUV-Licht umgewandelt wird, variabel einstellbar ist.

Dabei kann zur Berechnung des relativen Anteils insbesondere die Lichtenergie des jeweils von dem ersten bzw. zweiten Undulator erzeugten EUV-Lichts herangezogen werden.

Gemäß einer Ausführungsform ist die variable Einstellung des jeweiligen relativen Anteils, zu dem die Energie des Elektronenstrahls in von dem ersten Undulator erzeugtes EUV-Licht bzw. in von dem zweiten Undulator erzeugtes EUV-Licht umgewandelt wird, durch Modifikation des Elektronenstrahls (z.B. durch Modifikation der Gainlänge) vor dessen Eintritt in die Undulator-Anordnung durchführbar.

Gemäß einem weiteren Aspekt betrifft die Erfindung ein Verfahren zum Betreiben einer EUV-Lichtquelle für eine Beleuchtungseinrichtung einer mikrolithographischen Projektionsbelichtungsanlage, wobei die EUV-Lichtquelle eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls aufweist, wobei diese Undulator-Anordnung aufweist:

- einen ersten Undulator zur Erzeugung von EUV-Licht mit einem ersten Polarisationszustand; und

- wenigstens einen zweiten Undulator zur Erzeugung von EUV-Licht mit einem zweiten Polarisationszustand, wobei der zweite Polarisationszustand von dem ersten Polarisationszustand verschieden ist;

- wobei der zweite Undulator entlang der Ausbreitungsrichtung des Elektronenstrahls nach dem ersten Undulator angeordnet ist; und

- wobei im Betrieb der Undulator-Anordnung ein Umschalten zwischen einem ersten Betriebsmodus, in welchem sich der erste Undulator hinsichtlich der Erzeugung von EUV-Licht in Sättigung befindet, und wenigstens einem zweiten Betriebsmodus, in welchem sich der erste Undulator hinsichtlich der Erzeugung von EUV-Licht nicht in Sättigung befindet, erfolgt.

Gemäß einer Ausführungsform erfolgt das Umschalten zwischen dem ersten Betriebsmodus und dem zweiten Betriebsmodus durch Modifikation des Elektronenstrahls (z.B. durch Modifikation der Gainlänge) vor dessen Eintritt in die Undulator-Anordnung.

Gemäß einem weiteren Aspekt betrifft die Erfindung ein Verfahren zum Betreiben einer EUV-Lichtquelle für eine Beleuchtungseinrichtung einer mikrolithographischen Projektionsbelichtungsanlage, wobei die EUV-Lichtquelle eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls aufweist,

- wobei diese Undulator-Anordnung einen ersten Undulator zur Erzeugung von EUV-Licht mit einem ersten Polarisationszustand und wenigstens einen zweiten Undulator zur Erzeugung von EUV-Licht mit einem zweiten Polarisationszustand aufweist, wobei der zweite Polarisationszustand von dem ersten Polarisationszustand verschieden ist;

- wobei im Betrieb der Projektionsbelichtungsanlage von ersten Undulator erzeugtes EUV-Licht und von dem zweiten Undulator erzeugtes EUV-Licht jeweils in die Beleuchtungseinrichtung eingekoppelt wird; und

- wobei der jeweilige relative Anteil, zu dem die Energie des Elektronenstrahls in von dem ersten Undulator erzeugtes EUV-Licht bzw. in von dem zweiten Undulator erzeugtes EUV-Licht umgewandelt wird, variabel einstellbar ist.

Gemäß einer Ausführungsform erfolgt die variable Einstellung des jeweiligen relativen Anteils, zu dem die Energie des Elektronenstrahls in von dem ersten Undulator erzeugtes EUV-Licht bzw. in von dem zweiten Undulator erzeugtes EUV-Licht umgewandelt wird, durch Modifikation des Elektronenstrahls vor dessen Eintritt in die Undulator-Anordnung.

Gemäß einer Ausführungsform weist die EUV-Lichtquelle eine Mehrzahl von mit elektrischem Strom beaufschlagbaren Quadrupolmagneten zur Fokussierung des Elektronenstrahls auf, wobei das Umschalten zwischen dem ersten Betriebsmodus und dem zweiten Betriebsmodus zumindest teilweise durch Variation des elektrischen Stroms in wenigstens einem dieser Quadrupolmagnete erfolgt.

Gemäß einer Ausführungsform wird in einer Pupillenebene der Beleuchtungseinrichtung zumindest zeitweise eine näherungsweise tangentiale Polarisationsverteilung oder eine näherungsweise radiale Polarisationsverteilung erzeugt.

Gemäß einer Ausführungsform wird in einer Pupillenebene der Beleuchtungseinrichtung zumindest zeitweise unpolarisiertes Licht erzeugt.

Die Erfindung betrifft weiter auch ein Verfahren zur mikrolithographischen Herstellung mikrostrukturierter Bauelemente.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

KURZE BESCHREIBUNG DER ZEICHNUNGEN

Es zeigen:

Figur 1 eine schematische Darstellung zur Erläuterung des möglichen Aufbaus eines Freie-Elektronen-Lasers gemäß der vorliegenden Erfindung;

Figur 2-4 schematische Darstellungen zur Erläuterung des der vorliegenden Erfindung zugrundeliegenden Prinzips;

Figur 5-6 schematische Darstellungen zur Erläuterung des möglichen Aufbaus einer mikrolithographischen Projektionsbelichtungsanlage, in welcher die vorliegende Erfindung realisiert werden kann; und

Figur 7a-b schematische Darstellungen zur Erläuterung des möglichen Aufbaus eines Freie-Elektronen-Lasers; und

Figur 8 eine schematische Darstellung zur Erläuterung des möglichen Aufbaus eines Freie-Elektronen-Lasers gemäß einer weiteren Ausführungsform der vorliegenden Erfindung.

DETAILLIERTE BESCHREIBUNG BEVORZUGTER AUSFÜHRUNGSFORMEN

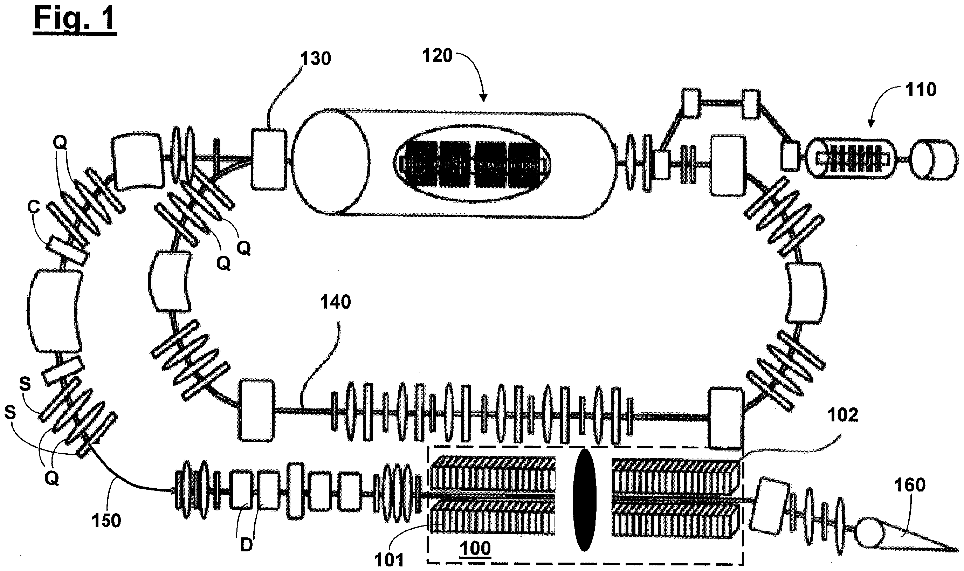

Fig. 1 zeigt eine schematische Darstellung zur Erläuterung des möglichen Aufbaus eines durch die EUV-Lichtquelle gemäß der vorliegenden Erfindung gebildeten Freie-Elektronen-Lasers.

Gemäß Fig. 1 wird bei einem solchen Freie-Elektronen-Laser ein von einer Elektronenquelle 110 erzeugter Elektronenstrahl mit Hilfe einer Beschleunigereinheit 120 auf eine relativistische Geschwindigkeit beschleunigt. Ein Dipolmagnet 130 lenkt die Elektronen abhängig von ihrer Energie auf einen ersten Elektronenstrahlpfad 140 oder einen zweiten Elektronenstrahlpfad 150, wobei auf diesen Elektronenstrahlpfaden 140, 150 jeweils eine Mehrzahl von Dipolmagneten (z.T. in Fig. 1 exemplarisch mit "D" bezeichnet), Quadrupolmagneten (z.T. in Fig. 1 exemplarisch mit "Q" bezeichnet) und Sextupolmagneten (z.T. in Fig. 1 exemplarisch mit "S" bezeichnet) angeordnet sind.

Nach einmaligem Durchlauf der Beschleuniger-Einheit 120 ist die Energie der Elektronen im Elektronenstrahl derart, dass diese Elektronen durch den mit "130" bezeichneten Dipolmagneten auf den ersten Elektronenstrahlpfad 140 gelenkt werden und infolgedessen die Beschleuniger-Einheit 120 erneut durchlaufen, wodurch diese Elektronen weiter beschleunigt werden. Beim zweiten Durchlauf des Dipolmagneten 130 ist die Energie der Elektronen im Elektronenstrahl derart, dass sie auf den zweiten Elektronenstrahlpfad 150 gelenkt werden. Das mehrfache Durchlaufen der Beschleuniger-Einheit 2 wird auch als Rezirkulatorkonzept bezeichnet und ist in der Veröffentlichung "Compact 13.5-nm free-electron laser for extreme ultraviolet lithography" von Y. Sokol, G. N. Kulipanov, A. N. Matveenko, O. A. Shevchenko und N. A. Vinokurov, Phys. Rev. Spec. Top., 14:040702, 2011, detailliert beschrieben. Die Erfindung ist jedoch nicht auf dieses Rezirkulatorkonzept beschränkt, sondern auch in einer anderen Konfiguration (ohne mehrfaches Durchlaufen der Beschleuniger-Einheit) realisierbar.

Die auf den zweiten Elektronenstrahlpfad 150 gelenkten Elektronen treffen auf eine Undulator-Anordnung 100. Diese Undulator-Anordnung 100 versetzt den Elektronenstrahl in eine sinusförmige periodische Bewegung. Aufgrund der Ablenkung der Elektronen senden die Elektronen Synchrotronstrahlung aus, welche infolge der relativistischen Bewegung der Elektronen nahezu vollständig vorwärts entlang der Elektronenbahn gerichtet ist. Strahlung, die in benachbarten Perioden der Undulator-Anordnung 100 ausgestrahlt wird, kann sich phasenrichtig überlagern. Die Wellenlänge des Freie-Elektronen-Lasers kann dabei durchgestimmt werden, indem die Energie der Elektronen, die Periode der Undulator-Anordnung 100 oder das Magnetfeld der Undulator-Anordnung 100 variiert werden.

Das von der Undulator-Anordnung 100 erzeugte EUV-Licht wird in die Beleuchtungseinrichtung einer in Fig. 1 lediglich schematisch angedeuteten Projektionslichtungsanlage 160 eingekoppelt.

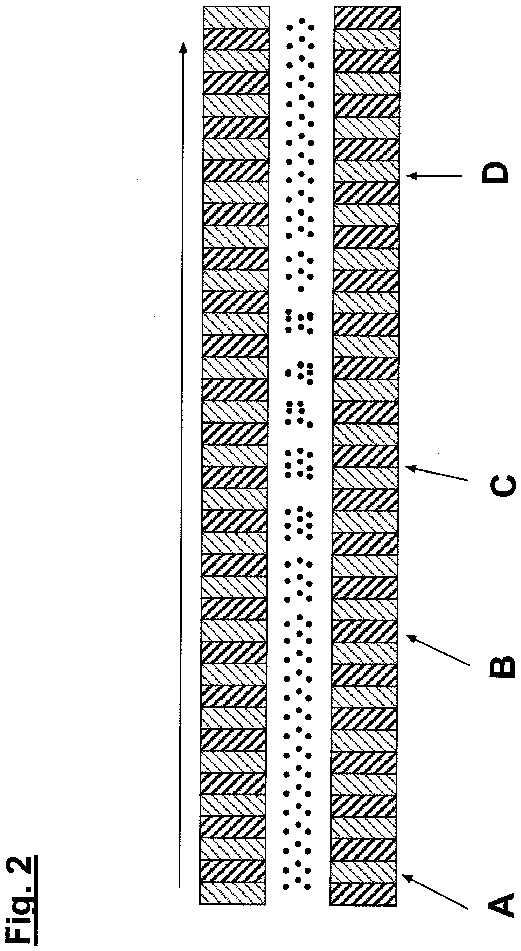

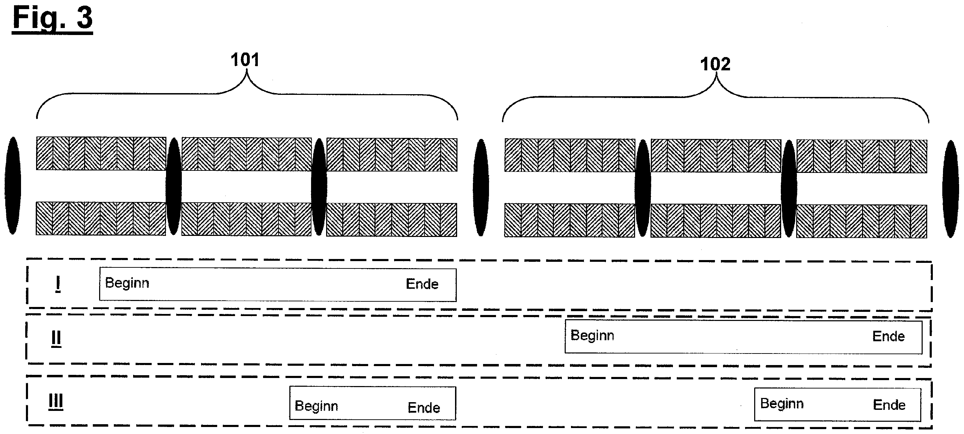

Fig. 2 und 3 zeigen schematische Darstellungen zur Erläuterung des der vorliegenden Erfindung zugrundeliegenden Prinzips.

Wie in Fig. 2 lediglich schematisch dargestellt, bilden sich beim Durchlauf des Elektronenstrahls durch die Undulator-Anordnung 100 aus den zunächst homogen verteilten Elektronen (Abschnitt "A") Elektronenpakete (sogenannte "Mikrobunches") von der Größenordnung der Wellenlänge (unter Berücksichtigung der Lorentz-Kontraktion aufgrund der relativistischen Geschwindigkeit der Elektronen) aus (Abschnitt "B"), wobei lediglich die in ein- und demselben Elektronenpaket befindlichen Elektronen zueinander kohärente Strahlung abgeben können. Die Laseraktion beginnt demzufolge, sobald die Elektronenpakete bzw. "Mikrobunches" hinreichend ausgeprägt sind (Abschnitt "C") und endet, sobald die Energiedispersion der Elektronen infolge der Laseraktion und dem damit einhergehenden Energieverlust sowie der demzufolge zunehmendem Energieunschärfe zu groß geworden ist bzw. zu einer Auflösung der Elektronenpakete bzw. "Mikrobunches" führt (Abschnitt "D").

Gemäß Fig. 3 weist nun die erfindungsgemäße Undulator-Anordnung 100 einen ersten Undulator 101 und einen zweiten Undulator 102 auf, wobei der erste und der zweite Undulator 101, 102 hinsichtlich ihrer jeweiligen Magnetanordnungen so ausgestaltet sind, dass die von ihnen jeweils emittierte elektromagnetische Strahlung voneinander verschiedene Polarisationszustände aufweist. Im konkreten Ausführungsbeispiel kann etwa der erste Undulator 101 derart ausgestaltet sein, dass das von ihm abgestrahlte Licht horizontal bzw. in x-Richtung polarisiert ist, und der zweite Undulator 102 kann derart ausgestaltet sein, dass das von ihm abgestrahlte Licht vertikal bzw. in y-Richtung polarisiert ist.

Ausgehend von dieser Undulator-Anordnung 100 kann nun erfindungsgemäß eine flexible Variation der jeweiligen Beträge der beiden Undulatoren 101, 102 zur insgesamt erzeugten elektromagnetischen Strahlung und damit eine flexible Einstellung des letztlich erzeugten Polarisationszustandes realisiert werden, wie im Folgenden erläutert wird.

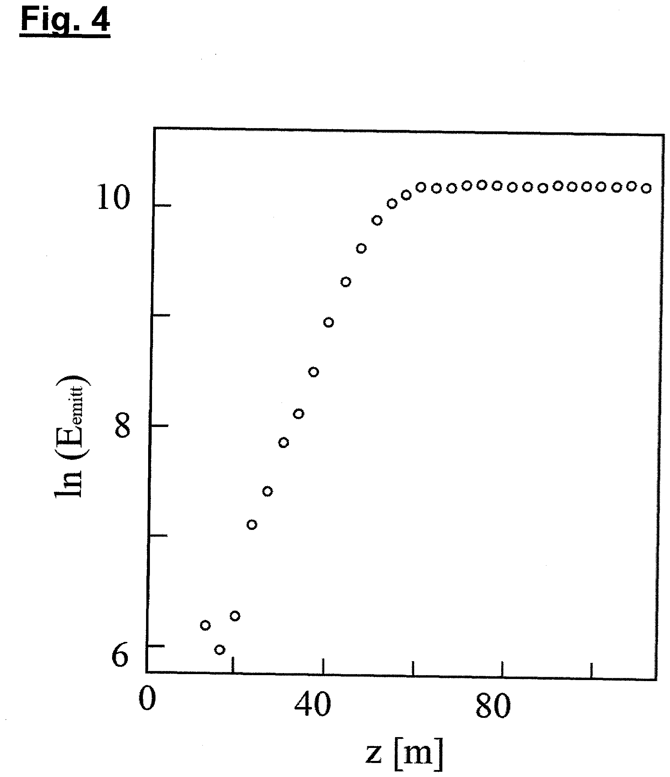

Grundsätzlich kommt es in einem Undulator hinsichtlich der Abhängigkeit der abgestrahlten Lichtintensität bzw. Energie vom Laufweg z vor dem Eintritt der Sättigung gemäß Fig. 4 zu einem exponentiellen Anstieg der abgestrahlten Lichtintensität bzw. Energie $E_{emitt}$ gemäß der Beziehung

$$I(z) = I_0 \cdot e^{z/L_g} \qquad (1)$$

wobei $L_g$ die sogenannte Gainlänge und $I_0$ die Lichtintensität am Eingang des Undulators bezeichnet.

Insbesondere kann gemäß einer Ausführungsform der Erfindung zur Verteilung der insgesamt abgestrahlten Energie auf die beiden Undulatoren 101, 102 (d.h. zur Variation der jeweiligen Beträge dieser Undulatoren 101, 102 zur insgesamt erzeugten elektromagnetischen Strahlung) die Gainlänge $L_g$ verändert werden. Diesem Ansatz liegt die Überlegung zugrunde, dass bei relativ kurzer Gainlänge die gesamte nutzbare Energie bereits im ersten Undulator 101 aus dem Elektronenstrahl entfernt wird, wobei anschließend die Energieunschärfe der Elektronen so groß ist, dass keine Laseraktion mehr möglich ist. Wird hingegen die Gainlänge relativ groß gewählt, wird im ersten Undulator 101 vergleichsweise wenig Licht erzeugt bzw. Energie aus dem Elektronenstrahl entnommen mit der Folge, dass die Laseraktion bzw. Lichterzeugung erst in dem zweiten Undulator 102 stattfindet.

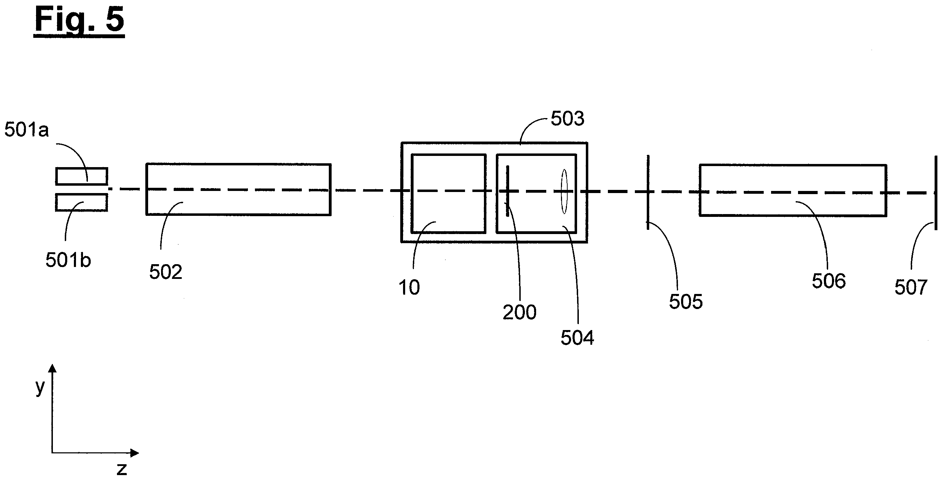

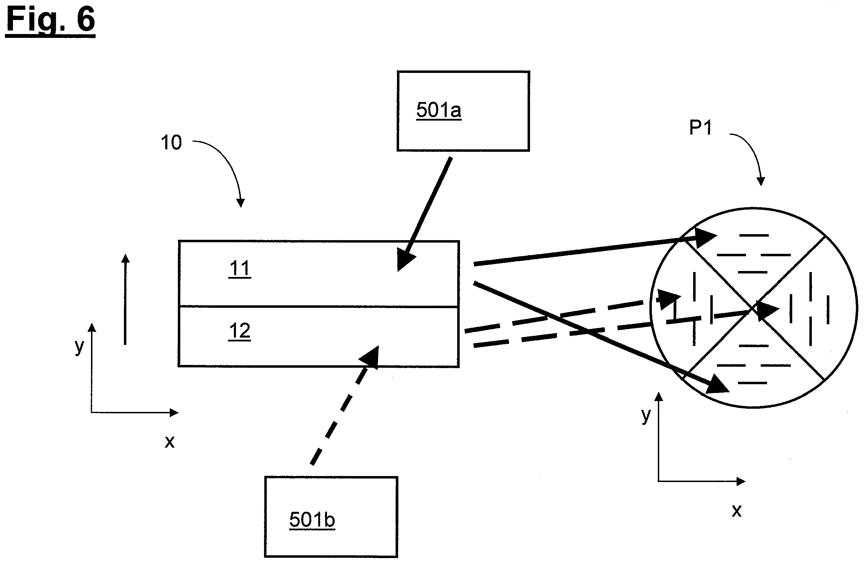

Wie in Fig. 3 schematisch angedeutet, können beispielsweise in einem ersten Szenario "I" sowohl der Einsatz als auch das Ende der Laseraktion auf Seiten des ersten Undulators 101 stattfinden, damit die gesamte von der Undulator-Anordnung freigesetzte Strahlung horizontal polarisiert ist. In einem zweiten Szenario "II" können sowohl der Einsatz als auch das Ende der Laseraktion auf Seiten des zweiten Undulators 102 stattfinden, damit die gesamte von der Undulator-Anordnung freigesetzte Strahlung vertikal polarisiert ist. In einem dritten Szenario "III" kann eine Laseraktion jeweils sowohl auf Seiten des ersten Undulators 101 als auch auf Seiten des zweiten Undulators 102 stattfinden, so dass sowohl horizontal polarisierte Strahlung als auch vertikal polarisierte Strahlung (in gleichen oder auch unterschiedlichen Anteilen) erzeugt wird. Im letzteren Falle kann können die betreffenden, unterschiedlich polarisierten Strahlen entweder räumlich getrennt der Beleuchtungseinrichtung (wie im Weiteren unter Bezugnahme auf Fig. 5 und Fig. 6 beschrieben) zugeführt werden, um ein bestimmtes polarisiertes Beleuchtungssetting wie z.B. ein quasi-tangential polarisiertes Beleuchtungssetting zu erzeugen, oder auch zur Erzeugung von unpolarisiertem Licht einander überlagert werden.

Eine beispielhafte quantitative Betrachtung zeigt, dass infolge des anhand von Fig. 4 gezeigten exponentiellen Verlaufs eine signifikante Variation der Verteilung der insgesamt abgestrahlten Energie auf die beiden Undulatoren 101, 102 und damit des letztlich bereitgestellten Polarisationszustandes bereits mit einer relativ geringen Änderung der Gainlänge erreicht werden kann.

Hierzu wird im Folgenden davon ausgegangen, dass die typische Länge eines Undulators zur Erzielung der Sättigung startend nur vom Rauschen des Elektronenstrahls dem 18-fachen Wert der Gainlänge entspricht. Wird ausgehend von einer solchen Ausgestaltung der Undulatoren 101, 102, bei welcher die gesamte Lichterzeugung durch den ersten Undulator 101 erfolgt, die Gainlänge um einen Faktor von beispielsweise 1.2 vergrößert, beträgt die Länge des ersten Undulators 101 effektiv nur noch 18/(1.2) = 15 Gainlängen, so dass im ersten Undulator drei Gainlängen bis zum Erreichen der Sättigung fehlen mit der Folge, dass die von dem ersten Undulator freigesetzte Energie bzw. Intensität nur etwa 5% der maximal möglichen Energie bzw. Intensität beträgt und stattdessen die verbleibenden ca. 95% von dem zweiten Undulator 102 freigesetzt werden.

Die Gainlänge $L_g$ ist abhängig sowohl vom Durchmesser des durch die Elektronenquelle erzeugten Elektronenstrahls als auch von der Energiedispersion, die dieser Elektronenstrahl bereits besitzt. Die Veränderung der Gainlänge $L_g$ zur Variation der Verteilung der insgesamt abgestrahlten Energie auf die beiden Undulatoren 101, 102 kann daher grundsätzlich in unterschiedlicher Weise erfolgen, wobei auch eine Kombination unterschiedlicher Optionen möglich ist:
Gemäß einer Option kann der elektrische Strom, mit welchem die im Aufbau von Fig. 1 gezeigten Quadrupolmagnete Q zur Fokussierung des Elektronenstrahls beaufschlagt werden, gezielt verändert werden. Dem liegt die Überlegung zugrunde, dass die durch die Quadrupolmagnete Q bewirkte, fortwährende Fokussierung des Elektronenstrahls einem Auseinanderlaufen Elektronen des Elektronenstrahls entgegenwirkt, wobei dieses Auseinanderlaufen der Elektronen zu größeren Winkeln zwischen jeweils einem bestimmten Elektron und der optischen Achse führt. Die Auswirkung dieser Winkelvergrößerung auf die Gainlänge kann durch den dimensionslosen Parameter

$$X_\varepsilon = \frac{L_{g0} \cdot 4\pi\varepsilon}{\beta_{av} \cdot \lambda_e} \qquad (2)$$

beschrieben werden, welcher zum Beispiel in P. Schmüser et al.: "Ultraviolet and Soft X-Ray Free-Electron Lasers: Introduction to Physical Principles, Experimental Results, Technological Challenges", STMP 229, Springer, Berlin Heidelberg 2008, DOI 10.1007/ 978-3-540-79572-8 näher erläutert wird.

In Gleichung (2) ist $\varepsilon$ die "Emittance" (d.h. das belegte Phasenraumvolumen) des Elektronenstrahls, also das Produkt aus dem RMS im Ortsraum und dem RMS im Winkelraum. Die Ausdehnung im Ortsraum wird in der Beschleunigerphysik nicht direkt spezifiziert, sondern wird als Produkt $\beta_{av}\varepsilon$ relativ zur Emittance angegeben. $\lambda_e$ ist die Wellenlänge der emittierten Strahlung. Diese ergibt sich aus der Periode $\lambda_u$ des Undulators durch zweifache Lorentzkontraktion, d.h., im Ruhesystem der Elektronen bewegt sich der Undulator relativistisch, und die von den Elektronen emittierte Strahlung muss in das Laborsystem transformiert werden. $L_{g0}$ ist die Gainlänge in erster Näherung, d.h., unter Vernachlässigung von Wechselwirkungseffekten und/oder Unschärfen im Orts-, Winkel- und Energieraum. $L_{g0}$ wirkt damit, wie erwartet, als Skalierungsfaktor für alle relevanten Effekte, die die Gainlänge verändern können.

Mit anderen Worten kann das Umschalten zwischen einem ersten Betriebsmodus, in welchem sich der erste Undulator 101 hinsichtlich der Erzeugung von EUV-Licht in Sättigung befindet, und wenigstens einen zweiten Betriebsmodus, in welchem sich der erste Undulator 101 hinsichtlich der Erzeugung von EUV-Licht nicht in Sättigung befindet, und damit auch die Steuerung des Polarisationszustands der durch die EUV-Lichtquelle erzeugten Strahlung zumindest teilweise durch Variation des elektrischen Stroms, mit dem die Quadrupolmagnete Q beaufschlagt werden, realisiert werden.

Gemäß einer weiteren Option kann eine Veränderung der Gainlänge $L_g$ bzw. eine Variation der Verteilung der insgesamt abgestrahlten Energie auf die beiden Undulatoren 101, 102 auch über die Energieunschärfe der durch die Elektronenquelle 110 erzeugten Elektronen erfolgen. Relevante Parameter für diese Energieunschärfe Elektronen sind zum einen die (Elektronen-)Temperatur der Elektrode, zum anderen die Energie der Photonen, mit denen Elektronen herausgelöst werden. Des Weiteren können auch Wechselwirkungen der Elektronen untereinander sowie zusätzliche elektrische Felder in den Umlenkmagneten zu einer Vergrößerung der Energieunschärfe führen. Die Auswirkung einer Energieunschärfe auf die Gainlänge kann durch den dimensionslosen Parameter

$$X_\gamma = \frac{L_{g0} \cdot 4\pi\sigma_\eta}{\lambda_u} \qquad (3)$$

beschrieben werden. $\sigma_\eta$ quantifiziert den RMS der Energiefluktuationen der Elektronen im Elektronenstrahl.

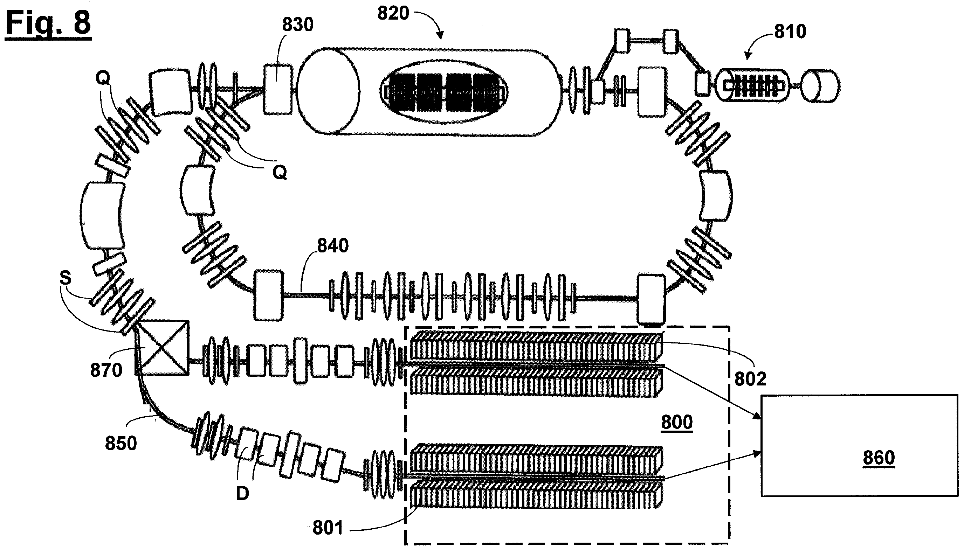

Fig. 8 zeigt eine schematische Darstellung zur Erläuterung des möglichen Aufbaus eines durch die EUV-Lichtquelle gemäß der vorliegenden Erfindung gebildeten Freie-Elektronen-Lasers gemäß einer weiteren Ausführungsform, wobei im Vergleich zu Fig. 1 analoge bzw. im Wesentlichen funktionsgleiche Komponenten mit um "700" erhöhten Bezugsziffern bezeichnet sind. Der Aufbau gemäß Fig. 8 unterscheidet sich von demjenigen aus Fig. 1 insbesondere dadurch, dass die Undulatoren 801, 802 nicht entlang der Ausbreitungsrichtung des Elektronenstrahls hintereinander, sondern parallel zueinander angeordnet sind, wobei sich im Elektronenstrahlpfad 850 eine Elektronenstrahl-Weiche 870 (z.B. in Form eines ansteuerbaren Magneten) befindet, über deren Ansteuerung die Elektronenpakete selektiv zu den Undulatoren 801, 802 der Undulator-Anordnung 800 lenkbar sind. Dabei wird sowohl das von dem ersten Undulator 801 erzeugte EUV-Licht als auch das von dem zweiten Undulator 802 erzeugte EUV-Licht in eine (in Fig. 8 lediglich schematisch angedeuteten) Projektionslichtungsanlage 860 (d.h. insbesondere in ein- und dieselbe Beleuchtungseinrichtung) eingekoppelt. Somit ist auch in dem Aufbau gemäß Fig. 8 der jeweilige relative Anteil, zu dem die Energie des Elektronenstrahls in von dem ersten Undulator erzeugtes EUV-Licht bzw. in von dem zweiten Undulator erzeugtes EUV-Licht umgewandelt wird, variabel einstellbar (wobei die Undulatoren z.B. auch in dieser Ausführungsform zueinander orthogonale Polarisationszustände erzeugen können). Dabei können auch bei dem Aufbau gemäß Fig. 8 die betreffenden, unterschiedlich polarisierten Strahlen entweder räumlich getrennt der Beleuchtungseinrichtung der Projektionslichtungsanlage 860 (wie im Weiteren unter Bezugnahme auf Fig. 5 und Fig. 6 beschrieben) zugeführt werden, um ein bestimmtes polarisiertes Beleuchtungssetting wie z.B. ein quasi-tangential polarisiertes Beleuchtungssetting zu erzeugen, oder auch zur Erzeugung von unpolarisiertem Licht einander überlagert werden.

Somit kann auch bei dem in Fig. 8 gezeigten Aufbau unter fortwährender Nutzung der gesamten, durch die erfindungsgemäße Undulator-Anordnung 800 freigesetzten Strahlungsenergie bzw. -intensität im Wege der Variation der relativen Beiträge der beiden Undulatoren 801, 802 zu dieser Gesamtintensität die flexible Einstellung der Polarisationsverteilung ohne signifikanten Lichtverlust erreicht werden.

Fig. 5-6 dienen zur lediglich schematischen und vereinfachten Darstellung des möglichen Aufbaus einer mikrolithographischen Projektionsbelichtungsanlage, in welcher die Erfindung realisiert werden kann. Gemäß Fig. 5 wird Licht über zwei Eingänge 501a, 501b (z.B. entsprechend den vorstehend beschriebenen Undulatoren 101, 102) über eine optische Strahlführungs- und -aufweitungseinheit 502 in eine Beleuchtungseinrichtung 503 eingekoppelt, welche eine strahlablenkende Anordnung 10 (wie im Weiteren anhand von Fig. 6 beschrieben) sowie - in einer optischen Einheit 504 zur Pupillenerzeugung - eine in einer Zwischenfeldebene befindliche Spiegelanordnung 200 aufweist. Eine durch die Beleuchtungseinrichtung 503 beleuchtete Maske (Retikel) 505 befindet sich in der Objektebene eines nachfolgenden Projektionsobjektivs 506, welche die Strukturen auf der Maske 505 auf einen in der Bildebene angeordneten Wafer 507 abbildet.

Die strahlablenkende Anordnung 10 kann gemäß Fig. 6 z.B. als Streifenspiegeleinheit ausgebildet sein, wobei "11" und "12" zwei unterschiedliche Streifenspiegel oder auch Gruppen von Streifenspiegeln darstellen können. Diese Streifenspiegel bzw. ersten Reflexionsflächen 11, 12,... sind jeweils um zwei zueinander senkrechte Kippachsen (welche im Ausführungsbeispiel in x- bzw. y-Richtung verlaufen) verkippbar, so dass das an den Streifenspiegeln bzw. ersten Reflexionsflächen 11, 12,... reflektierte Licht je nach Verkippung des jeweiligen Streifenspiegels in unterschiedliche, grundsätzlich beliebig einstellbare Raumwinkel reflektiert werden kann. Das an den einzelnen Reflexionsflächen bzw. Streifenspiegeln der strahlablenkenden Anordnung 10 reflektierte Licht, welches entweder von dem ersten Eingang 501a oder dem zweiten Eingang 501b stammt und einen entsprechenden, von dem betreffenden Undulator 101, 102 bereitgestellten Polarisationszustand aufweist, wird über die oben genannte (in Fig. 6 nicht dargestellte) Spiegelanordnung 200 mit einer Mehrzahl unabhängig voneinander verstellbarer Spiegelelemente in eine Pupillenebene (z.B. auf einen in der Pupillenebene befindlichen Pupillenfacettenspiegel) gelenkt, in der entsprechend der Ausrichtung der ersten Reflexionsflächen der strahlablenkenden Anordnung 10 sowie der Spiegelelemente der Spiegelanordnung ein gewünschtes polarisiertes Beleuchtungssetting P1 erzeugt wird. Bei dem gewünschten polarisierten Beleuchtungssetting kann es sich z.B. wie in Fig. 6 angedeutet - jedoch ohne das die Erfindung hierauf beschränkt wäre - um ein näherungsweise tangential polarisiertes Beleuchtungssetting (auch als quasitangential polarisiertes Beleuchtungssetting bezeichnet) handeln, welches in für sich bekannter Weise eine kontrastreiche Abbildung ermöglicht, wobei die in x-Richtung einander gegenüberliegenden Beleuchtungspole linear in y-Richtung polarisiert sind und die in y-Richtung einander gegenüberliegenden Beleuchtungspole in x-Richtung polarisiert sind. Bei der erzeugten Polarisationsverteilung kann es sich ferner beispielsweise auch um eine zumindest näherungsweise radiale Polarisationsverteilung handeln.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist.

Die vorliegende Anmeldung umfasst Aspekte, die in den nachfolgenden Sätzen definiert sind, welche einen Teil der Beschreibung bilden, aber keine Patentansprüche darstellen, im Einklang mit der Entscheidung J15/88 der juristischen Beschwerdekammer des Europäischen Patentamts.

1. EUV-Lichtquelle für eine Beleuchtungseinrichtung einer mikrolithographischen Projektionsbelichtungsanlage, wobei die EUV-Lichtquelle eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls aufweist, wobei diese Undulator-Anordnung aufweist:

- einen ersten Undulator zur Erzeugung von EUV-Licht mit einem ersten Polarisationszustand; und
- wenigstens einen zweiten Undulator zur Erzeugung von EUV-Licht mit einem zweiten Polarisationszustand, wobei der zweite Polarisationszustand von dem ersten Polarisationszustand verschieden ist;
- wobei der zweite Undulator entlang der Ausbreitungsrichtung des Elektronenstrahls nach dem ersten Undulator angeordnet ist; und
- wobei die Undulator-Anordnung derart konfiguriert ist, dass diese einen ersten Betriebsmodus, in welchem sich der erste Undulator hinsichtlich der Erzeugung von EUV-Licht in Sättigung befindet, und wenigstens einen zweiten Betriebsmodus, in welchem sich der erste Undulator hinsichtlich der Erzeugung von EUV-Licht nicht in Sättigung befindet, aufweist.

2. EUV-Lichtquelle nach Satz 1, dadurch gekennzeichnet, dass die Undulator-Anordnung derart konfiguriert ist, dass in wenigstens einem Betriebsmodus die Erzeugung des EUV-Lichtes zu einem Anteil von wenigstens 90% durch den zweiten Undulator erfolgt.

3. EUV-Lichtquelle nach Satz 1 oder 2, dadurch gekennzeichnet, dass die Undulator-Anordnung derart konfiguriert ist, dass in wenigstens einem Betriebsmodus die Erzeugung des EUV-Lichtes zu einem Anteil von wenigstens 90% durch den ersten Undulator erfolgt.

4. EUV-Lichtquelle nach einem der Sätze 1 bis 3, dadurch gekennzeichnet, dass die Undulator-Anordnung derart konfiguriert ist, dass in wenigstens einem Betriebsmodus die Erzeugung des EUV-Lichtes zu einem Anteil von wenigstens 40% durch den ersten Undulator sowie zu einem Anteil von wenigstens 40% durch den zweiten Undulator erfolgt.

5. EUV-Lichtquelle nach einem der vorhergehenden Sätze, dadurch gekennzeichnet, dass der Polarisationszustand des durch die Undulator-Anordnung erzeugten EUV-Lichtes durch Modifikation des Elektronenstrahls vor dessen Eintritt in die Undulator-Anordnung variabel einstellbar ist.

6. EUV-Lichtquelle nach einem der vorhergehenden Sätze, dadurch gekennzeichnet, dass der Polarisationszustand des durch die Undulator-Anordnung erzeugten EUV-Lichtes durch Modifikation der Gainlänge des Elektronenstrahls vor dessen Eintritt in die Undulator-Anordnung variabel einstellbar ist.

7. EUV-Lichtquelle nach einem der vorhergehenden Sätze, dadurch gekennzeichnet, dass diese eine Mehrzahl von mit elektrischem Strom beaufschlagbaren Quadrupolmagneten zur Fokussierung des Elektronenstrahls aufweist, wobei das Umschalten zwischen dem ersten Betriebsmodus und dem zweiten Betriebsmodus zumindest teilweise durch Variation des elektrischen Stroms in wenigstens einem dieser Quadrupolmagnete erfolgt.

8. EUV-Lichtquelle nach einem der vorhergehenden Sätze, dadurch gekennzeichnet, dass der erste Polarisationszustand und der zweite Polarisationszustand zueinander orthogonal sind.

9. EUV-Lichtquelle nach einem der vorhergehenden Sätze, dadurch gekennzeichnet, dass die Undulator-Anordnung weiter derart konfiguriert ist, dass ein von dem ersten Undulator erzeugter erster Lichtstrahl und ein von dem zweiten Undulator erzeugter zweiter Lichtstrahl voneinander räumlich getrennt der Beleuchtungseinrichtung zuführbar sind.

10. EUV-Lichtquelle nach einem der vorhergehenden Sätze, dadurch gekennzeichnet, dass der erste Undulator und der zweite Undulator derart angeordnet sind, dass die Ausbreitungsrichtung des Elektronenstrahls in dem ersten Undulator und die Ausbreitungsrichtung des Elektronenstrahls in dem zweiten Undulator zueinander verkippt sind.

11. EUV-Lichtquelle nach einem der vorhergehenden Sätze, dadurch gekennzeichnet, dass die Undulator-Anordnung weiter derart konfiguriert ist, dass ein von dem ersten Undulator erzeugter erster Lichtstrahl und ein von dem zweiten Undulator erzeugter zweiter Lichtstrahl bei Zuführung zu der Beleuchtungseinrichtung einander überlagerbar sind.

12. Mikrolithographische Projektionsbelichtungsanlage mit einer Beleuchtungseinrichtung und einem Projektionsobjektiv, dadurch gekennzeichnet, dass diese eine EUV-Lichtquelle nach einem der vorhergehenden Sätze aufweist.

13. Mikrolithographische Projektionsbelichtungsanlage mit einer EUV-Lichtquelle, einer Beleuchtungseinrichtung und einem Projektionsobjektiv, wobei die EUV-Lichtquelle eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls aufweist,

- wobei diese Undulator-Anordnung einen ersten Undulator zur Erzeugung von EUV-Licht mit einem ersten Polarisationszustand und wenigstens einen zweiten Undulator zur Erzeugung von EUV-Licht mit einem zweiten Polarisationszustand aufweist, wobei der zweite Polarisationszustand von dem ersten Polarisationszustand verschieden ist;
- wobei im Betrieb der Projektionsbelichtungsanlage von ersten Undulator erzeugtes EUV-Licht und von dem zweiten Undulator erzeugtes EUV-Licht jeweils in die Beleuchtungseinrichtung eingekoppelt wird; und
- wobei der jeweilige relative Anteil, zu dem die Energie des Elektronenstrahls in von dem ersten Undulator erzeugtes EUV-Licht bzw. in von dem zweiten Undulator erzeugtes EUV-Licht umgewandelt wird, variabel einstellbar ist.

14. Mikrolithographische Projektionsbelichtungsanlage nach Satz 13, dadurch gekennzeichnet, dass die variable Einstellung des jeweiligen relativen Anteils, zu dem die Energie des Elektronenstrahls in von dem ersten Undulator erzeugtes EUV-Licht bzw. in von dem zweiten Undulator erzeugtes EUV-Licht umgewandelt wird, durch Modifikation des Elektronenstrahls vor dessen Eintritt in die Undulator-Anordnung durchführbar ist.

15. Verfahren zum Betreiben einer EUV-Lichtquelle für eine Beleuchtungseinrichtung einer mikrolithographischen Projektionsbelichtungsanlage, wobei die EUV-Lichtquelle eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls aufweist, wobei diese Undulator-Anordnung aufweist:

- einen ersten Undulator zur Erzeugung von EUV-Licht mit einem ersten Polarisationszustand; und
- wenigstens einen zweiten Undulator zur Erzeugung von EUV-Licht mit einem zweiten Polarisationszustand, wobei der zweite Polarisationszustand von dem ersten Polarisationszustand verschieden ist;
- wobei der zweite Undulator entlang der Ausbreitungsrichtung des Elektronenstrahls nach dem ersten Undulator angeordnet ist; und
- wobei im Betrieb der Undulator-Anordnung ein Umschalten zwischen einem ersten Betriebsmodus, in welchem sich der erste Undulator hinsichtlich der Erzeugung von EUV-Licht in Sättigung befindet, und wenigstens einem zweiten Betriebsmodus, in welchem sich der erste Undulator hinsichtlich der Erzeugung von EUV-Licht nicht in Sättigung befindet, erfolgt.

16. Verfahren nach Satz 15, dadurch gekennzeichnet, dass das Umschalten zwischen dem ersten Betriebsmodus und dem zweiten Betriebsmodus durch Modifikation des Elektronenstrahls vor dessen Eintritt in die Undulator-Anordnung erfolgt.

17. Verfahren zum Betreiben einer EUV-Lichtquelle für eine Beleuchtungseinrichtung einer mikrolithographischen Projektionsbelichtungsanlage, wobei die EUV-Lichtquelle eine Elektronenquelle zum Erzeugen eines Elektronenstrahls, eine Beschleuniger-Einheit zum Beschleunigen dieses Elektronenstrahls sowie eine Undulator-Anordnung zur Erzeugung von EUV-Licht durch Ablenkung des Elektronenstrahls aufweist,

- wobei diese Undulator-Anordnung einen ersten Undulator zur Erzeugung von EUV-Licht mit einem ersten Polarisationszustand und wenigstens einen zweiten Undulator zur Erzeugung von EUV-Licht mit einem zweiten Polarisationszustand aufweist, wobei der zweite Polarisationszustand von dem ersten Polarisationszustand verschieden ist;
- wobei im Betrieb der Projektionsbelichtungsanlage von ersten Undulator erzeugtes EUV-Licht und von dem zweiten Undulator erzeugtes EUV-Licht jeweils in die Beleuchtungseinrichtung eingekoppelt wird; und
- wobei der jeweilige relative Anteil, zu dem die Energie des Elektronenstrahls in von dem ersten Undulator erzeugtes EUV-Licht bzw. in von dem zweiten Undulator erzeugtes EUV-Licht umgewandelt wird, variabel eingestellt wird.

18. Verfahren nach Satz 17, dadurch gekennzeichnet, dass die variable Einstellung des jeweiligen relativen Anteils, zu dem die Energie des Elektronenstrahls in von dem ersten Undulator erzeugtes EUV-Licht bzw. in von dem zweiten Undulator erzeugtes EUV-Licht umgewandelt wird, durch Modifikation des Elektronenstrahls vor dessen Eintritt in die Undulator-Anordnung erfolgt.

19. Verfahren nach einem der Sätze 15 bis 18, dadurch gekennzeichnet, dass die EUV-Lichtquelle eine Mehrzahl von mit elektrischem Strom beaufschlagbaren Quadrupolmagneten zur Fokussierung des Elektronenstrahls aufweist, wobei das Umschalten zwischen dem ersten Betriebsmodus und dem zweiten Betriebsmodus zumindest teilweise durch Variation des elektrischen Stroms in wenigstens einem dieser Quadrupolmagnete erfolgt.

20. Verfahren nach einem der Sätze 15 bis 19, dadurch gekennzeichnet, dass in einer Pupillenebene der Beleuchtungseinrichtung zumindest zeitweise eine näherungsweise tangentiale Polarisationsverteilung oder eine näherungsweise radiale Polarisationsverteilung erzeugt wird.

21. Verfahren nach einem der Sätze 15 bis 20, dadurch gekennzeichnet, dass in einer Pupillenebene der Beleuchtungseinrichtung zumindest zeitweise unpolarisiertes Licht erzeugt wird.

22. Verfahren zur mikrolithographischen Herstellung mikrostrukturierter Bauelemente mit folgenden Schritten:

- Bereitstellen eines Substrats, auf das zumindest teilweise eine Schicht aus einem lichtempfindlichen Material aufgebracht ist;
- Bereitstellen einer Maske, die abzubildende Strukturen aufweist;
- Bereitstellen einer mikrolithographischen Projektionsbelichtungsanlage nach einem der Sätze 12 bis 14; und
- Projizieren wenigstens eines Teils der Maske auf einen Bereich der Schicht mit Hilfe der Projektionsbelichtungsanlage.

**Patentansprüche**

1. EUV-Lichtquelle für eine Beleuchtungseinrichtung einer mikrolithographischen Projektionsbelichtungsanlage, wobei die EUV-Lichtquelle eine Elektronenquelle (110) zum Erzeugen eines Elektronenstrahls, eine Beschleuniger-Einheit (120) zum Beschleunigen dieses Elektronenstrahls sowie eine Undulator-Anordnung (100) zur Erzeugung von EUV-Licht durch Ablenkung des Elektronenstrahls aufweist, wobei diese Undulator-Anordnung (100) aufweist:

- einen ersten Undulator (101) zur Erzeugung von EUV-Licht mit einem ersten Polarisationszustand; und
- wenigstens einen zweiten Undulator (102) zur Erzeugung von EUV-Licht mit einem zweiten Polarisationszustand, wobei der zweite Polarisationszustand von dem ersten Polarisationszustand verschieden ist;
- wobei der zweite Undulator (102) entlang der Ausbreitungsrichtung des Elektronenstrahls nach dem ersten Undulator (101) angeordnet ist; und
- wobei die Undulator-Anordnung (100) derart konfiguriert ist, dass diese einen ersten Betriebsmodus aufweist, in welchem sich der erste Undulator (101) hinsichtlich der Erzeugung von EUV-Licht in Sättigung befindet,

**dadurch gekennzeichnet, dass** die Undulator-Anordnung (100) wenigstens einen zweiten Betriebsmodus aufweist, in welchem sich der erste Undulator (101) hinsichtlich der Erzeugung von EUV-Licht nicht in Sättigung befindet.

2. EUV-Lichtquelle nach Anspruch 1, **dadurch gekennzeichnet, dass** die Undulator-Anordnung (100) derart konfiguriert ist, dass in wenigstens einem Betriebsmodus die Erzeugung des EUV-Lichtes zu einem Anteil von wenigstens 90% durch den zweiten Undulator (102) erfolgt.

3. EUV-Lichtquelle nach Anspruch 1 **dadurch gekennzeichnet, dass** die Undulator-Anordnung (100) derart konfiguriert ist, dass in wenigstens einem Betriebsmodus die Erzeugung des EUV-Lichtes zu einem Anteil von wenigstens 90% durch den ersten Undulator (101) erfolgt.

4. EUV-Lichtquelle nach einem der Ansprüche 1 bis 3, **dadurch gekennzeichnet, dass** die Undulator-Anordnung (100) derart konfiguriert ist, dass in wenigstens einem Betriebsmodus die Erzeugung des EUV-Lichtes zu einem Anteil von wenigstens 40% durch den ersten Undulator (101) sowie zu einem Anteil von wenigstens 40% durch den zweiten Undulator (102) erfolgt.

5. EUV-Lichtquelle nach einem der vorhergehenden Ansprüche, **dadurch gekennzeichnet, dass** der Polarisationszustand des durch die Undulator-Anordnung (100) erzeugten EUV-Lichtes durch Modifikation des Elektronenstrahls vor dessen Eintritt in die Undulator-Anordnung (100) variabel einstellbar ist.

6. EUV-Lichtquelle nach einem der vorhergehenden Ansprüche, **dadurch gekennzeichnet, dass** der Polarisationszustand des durch die Undulator-Anordnung (100) erzeugten EUV-Lichtes durch Modifikation der Gainlänge des Elektronenstrahls vor dessen Eintritt in die Undulator-Anordnung (100) variabel einstellbar ist.

7. EUV-Lichtquelle nach einem der vorhergehenden Ansprüche, **dadurch gekennzeichnet, dass** diese eine Mehrzahl von mit elektrischem Strom beaufschlagbaren Quadrupolmagneten zur Fokussierung des Elektronenstrahls aufweist, wobei das Umschalten zwischen dem ersten Betriebsmodus und dem zweiten Betriebsmodus zumindest teilweise durch Variation des elektrischen Stroms in wenigstens einem dieser Quadrupolmagnete erfolgt.

8. EUV-Lichtquelle nach einem der vorhergehenden Ansprüche, **dadurch gekennzeichnet, dass** der erste Polarisationszustand und der zweite Polarisationszustand zueinander orthogonal sind.

9. Mikrolithographische Projektionsbelichtungsanlage mit einer Beleuchtungseinrichtung (503) und einem Projektionsobjektiv (506), **dadurch gekennzeichnet, dass** diese eine EUV-Lichtquelle nach einem der vorhergehenden Ansprüche aufweist.

10. Mikrolithographische Projektionsbelichtungsanlage mit einer EUV-Lichtquelle, einer Beleuchtungseinrichtung (503) und einem Projektionsobjektiv (506), wobei die EUV-Lichtquelle eine Elektronenquelle (110, 810) zum Erzeugen eines Elektronenstrahls, eine Beschleuniger-Einheit (120, 820) zum Beschleunigen dieses Elektronenstrahls sowie eine Undulator-Anordnung (100, 800) zur Erzeugung von EUV-Licht durch Ablenkung des Elektronenstrahls aufweist,

   • wobei diese Undulator-Anordnung (100, 800) einen ersten Undulator (101, 801) zur Erzeugung von EUV-Licht mit einem ersten Polarisationszustand und wenigstens einen zweiten Undulator (102, 802) zur Erzeugung von EUV-Licht mit einem zweiten Polarisationszustand aufweist, wobei der zweite Polarisationszustand von dem ersten Polarisationszustand verschieden ist;
   • wobei im Betrieb der Projektionsbelichtungsanlage von ersten Undulator (101, 801) erzeugtes EUV-Licht und von dem zweiten Undulator (102, 802) erzeugtes EUV-Licht jeweils in die Beleuchtungseinrichtung (503) eingekoppelt wird; und
   • wobei der jeweilige relative Anteil, zu dem die Energie des Elektronenstrahls in von dem ersten Undulator (101, 801) erzeugtes EUV-Licht bzw. in von dem zweiten Undulator (102, 802) erzeugtes EUV-Licht umgewandelt wird, variabel einstellbar ist.

11. Mikrolithographische Projektionsbelichtungsanlage nach Anspruch 10, **dadurch gekennzeichnet, dass** die variable Einstellung des jeweiligen relativen Anteils, zu dem die Energie des Elektronenstrahls in von dem ersten Undulator (101, 801) erzeugtes EUV-Licht bzw. in von dem zweiten Undulator (102, 802) erzeugtes EUV-Licht umgewandelt wird, durch Modifikation des Elektronenstrahls vor dessen Eintritt in die Undulator-Anordnung (100, 800) durchführbar ist.

12. Verfahren zum Betreiben einer EUV-Lichtquelle für eine Beleuchtungseinrichtung einer mikrolithographischen Projektionsbelichtungsanlage, wobei die EUV-Lichtquelle eine Elektronenquelle (110) zum Erzeugen eines Elektronenstrahls, eine Beschleuniger-Einheit (120) zum Beschleunigen dieses Elektronenstrahls sowie eine Undulator-Anordnung (100) zur Erzeugung von EUV-Licht durch Ablenkung des Elektronenstrahls aufweist, wobei diese Undulator-Anordnung (100) aufweist:

   • einen ersten Undulator (101) zur Erzeugung von EUV-Licht mit einem ersten Polarisationszustand; und
   • wenigstens einen zweiten Undulator (102) zur Erzeugung von EUV-Licht mit einem zweiten Polarisationszustand, wobei der zweite Polarisationszustand von dem ersten Polarisationszustand verschieden ist;
   • wobei der zweite Undulator (102) entlang der Ausbreitungsrichtung des Elektronenstrahls nach dem ersten Undulator (101) angeordnet ist; und
   • wobei im Betrieb der Undulator-Anordnung (100) ein Umschalten zwischen einem ersten Betriebsmodus, in welchem sich der erste Undulator (101) hinsichtlich der Erzeugung von EUV-Licht in Sättigung befindet, und wenigstens einem zweiten Betriebsmodus, in welchem sich der erste Undulator (101) hinsichtlich der Erzeugung von EUV-Licht nicht in Sättigung befindet, erfolgt.

13. Verfahren nach Anspruch 12, **dadurch gekennzeichnet, dass** das Umschalten zwischen dem ersten Betriebsmodus und dem zweiten Betriebsmodus durch Modifikation des Elektronenstrahls vor dessen Eintritt in die Undulator-Anordnung (100) erfolgt.

**14.** Verfahren zum Betreiben einer EUV-Lichtquelle für eine Beleuchtungseinrichtung einer mikrolithographischen Projektionsbelichtungsanlage, wobei die EUV-Lichtquelle eine Elektronenquelle (110) zum Erzeugen eines Elektronenstrahls, eine Beschleuniger-Einheit (120) zum Beschleunigen dieses Elektronenstrahls sowie eine Undulator-Anordnung (100) zur Erzeugung von EUV-Licht durch Ablenkung des Elektronenstrahls aufweist,

· wobei diese Undulator-Anordnung (100, 800) einen ersten Undulator (101, 801) zur Erzeugung von EUV-Licht mit einem ersten Polarisationszustand und wenigstens einen zweiten Undulator (102, 802) zur Erzeugung von EUV-Licht mit einem zweiten Polarisationszustand aufweist, wobei der zweite Polarisationszustand von dem ersten Polarisationszustand verschieden ist;
· wobei im Betrieb der Projektionsbelichtungsanlage von ersten Undulator (101, 801) erzeugtes EUV-Licht und von dem zweiten Undulator (102, 802) erzeugtes EUV-Licht jeweils in die Beleuchtungseinrichtung (503) eingekoppelt wird; und
· wobei der jeweilige relative Anteil, zu dem die Energie des Elektronenstrahls in von dem ersten Undulator (101, 801) erzeugtes EUV-Licht bzw. in von dem zweiten Undulator (102, 802) erzeugtes EUV-Licht umgewandelt wird, variabel eingestellt wird.

**15.** Verfahren zur mikrolithographischen Herstellung mikrostrukturierter Bauelemente mit folgenden Schritten:

· Bereitstellen eines Substrats, auf das zumindest teilweise eine Schicht aus einem lichtempfindlichen Material aufgebracht ist;
· Bereitstellen einer Maske (505), die abzubildende Strukturen aufweist;
· Bereitstellen einer mikrolithographischen Projektionsbelichtungsanlage nach einem der Ansprüche 9 bis 11; und
· Projizieren wenigstens eines Teils der Maske (505) auf einen Bereich der Schicht mit Hilfe der Projektionsbelichtungsanlage.

**Claims**

**1.** EUV light source for an illumination device of a microlithographic projection exposure apparatus, wherein the EUV light source comprises an electron source (110) for generating an electron beam, an accelerator unit (120) for accelerating said electron beam, and an undulator arrangement (100) for generating EUV light by deflecting the electron beam,

wherein said undulator arrangement (100) comprises:

· a first undulator (101) for generating EUV light having a first polarization state; and
· at least one second undulator (102) for generating EUV light having a second polarization state, wherein the second polarization state is different than the first polarization state;
· wherein the second undulator (102) is arranged downstream of the first undulator (101) along the direction of propagation of the electron beam; and
· wherein the undulator arrangement (100) is configured in such a way that it has a first operating mode, in which the first undulator (101) is in saturation with regard to the generation of EUV light, **characterized in that** the undulator arrangement (100) has at least one second operating mode, in which the first undulator (101) is not in saturation with regard to the generation of EUV light.

**2.** EUV light source according to Claim 1, **characterized in that** the undulator arrangement (100) is configured in such a way that in at least one operating mode a proportion of at least 90% of the generation of the EUV light is effected by the second undulator (102).

**3.** EUV light source according to Claim 1, **characterized in that** the undulator arrangement (100) is configured in such a way that in at least one operating mode a proportion of at least 90% of the generation of the EUV light is effected by the first undulator (101).

**4.** EUV light source according to any of Claims 1 to 3, **characterized in that** the undulator arrangement (100) is configured in such a way that in at least one operating mode a proportion of at least 40% of the generation of the EUV light is effected by the first undulator (101) and a proportion of at least 40% of said generation is effected by the second undulator (102).

**5.** EUV light source according to any of the preceding claims, **characterized in that** the polarization state of the EUV light generated by the undulator arrangement (100) is settable in a variable manner by the modification of the electron beam before the latter enters the undulator arrangement (100).

**6.** EUV light source according to any of the preceding claims, **characterized in that** the polarization state of the EUV light generated by the undulator arrangement (100) is settable in a variable manner by the modification of the gain length of the electron beam before the latter enters the undulator arrangement (100).

7.  EUV light source according to any of the preceding claims, **characterized in that** it comprises a plurality of quadrupole magnets for focusing the electron beam, to which magnets electric current can be applied, wherein the switching between the first operating mode and the second operating mode is effected at least partly by variation of the electric current in at least one of said quadrupole magnets.

8.  EUV light source according to any of the preceding claims, **characterized in that** the first polarization state and the second polarization state are orthogonal with respect to one another.

9.  Microlithographic projection exposure apparatus comprising an illumination device (503) and a projection lens (506), **characterized in that** it comprises an EUV light source according to any of the preceding claims.

10. Microlithographic projection exposure apparatus comprising an EUV light source, an illumination device (503) and a projection lens (506), wherein the EUV light source comprises an electron source (110, 810) for generating an electron beam, an accelerator unit (120, 820) for accelerating said electron beam and an undulator arrangement (100, 800) for generating EUV light by deflecting the electron beam,

    • wherein said undulator arrangement (100, 800) comprises a first undulator (101, 801) for generating EUV light having a first polarization state and at least one second undulator (102, 802) for generating EUV light having a second polarization state, wherein the second polarization state is different than the first polarization state;
    • wherein during the operation of the projection exposure apparatus EUV light generated by the first undulator (101, 801) and EUV light generated by the second undulator (102, 802) are respectively coupled into the illumination device (503); and
    • wherein the respective relative proportion in which the energy of the electron beam is converted into EUV light generated by the first undulator (101, 801) and respectively into EUV light generated by the second undulator (102, 802) is settable in a variable manner.

11. Microlithographic projection exposure apparatus according to Claim 10, **characterized in that** the variable setting of the respective relative proportion in which the energy of the electron beam is converted into EUV light generated by the first undulator (101, 801) and respectively into EUV light generated by the second undulator (102, 802) can be carried out by the modification of the electron beam before the latter enters the undulator arrangement (100, 800).

12. Method for operating an EUV light source for an illumination device of a microlithographic projection exposure apparatus, wherein the EUV light source comprises an electron source (110) for generating an electron beam, an accelerator unit (120) for accelerating said electron beam, and an undulator arrangement (100) for generating EUV light by deflecting the electron beam, wherein said undulator arrangement (100) comprises:

    • a first undulator (101) for generating EUV light having a first polarization state; and
    • at least one second undulator (102) for generating EUV light having a second polarization state, wherein the second polarization state is different than the first polarization state; and
    • wherein the second undulator (102) is arranged downstream of the first undulator (101) along the direction of propagation of the electron beam; and
    • wherein during the operation of the undulator arrangement (100) switching is effected between a first operating mode, in which the first undulator (101) is in saturation with regard to the generation of EUV light, and at least one second operating mode, in which the first undulator (101) is not in saturation with regard to the generation of EUV light.

13. Method according to Claim 12, **characterized in that** the switching between the first operating mode and the second operating mode is effected by modification of the electron beam before the latter enters the undulator arrangement (100).

14. Method for operating an EUV light source for an illumination device of a microlithographic projection exposure apparatus, wherein the EUV light source comprises an electron source (110) for generating an electron beam, an accelerator unit (120) for accelerating said electron beam, and an undulator arrangement (100) for generating EUV light by deflecting the electron beam,

    • wherein said undulator arrangement (100, 800) comprises a first undulator (101, 801) for generating EUV light having a first polarization state and at least one second undulator (102, 802) for generating EUV light having a second polarization state, wherein the second polarization state is different than the first polarization state;
    • wherein during the operation of the projection exposure apparatus EUV light generated by the first undulator (101, 801) and EUV light generated by the second undulator (102, 802) are respectively coupled into the illumination device (503); and

• wherein the respective relative proportion in which the energy of the electron beam is converted into EUV light generated by the first undulator (101, 801) and respectively into EUV light generated by the second undulator (102, 802) is settable in a variable manner.

15. Method for microlithographically producing microstructured components comprising the following steps:

• providing a substrate, to which a layer composed of a light-sensitive material is at least partly applied;
• providing a mask (505) having structures to be imaged;
• providing a microlithographic projection exposure apparatus according to any of Claims 9 to 11; and
• projecting at least one part of the mask (505) onto a region of the layer with the aid of the projection exposure apparatus.

**Revendications**

1. Source de lumière EUV pour un dispositif d'éclairage d'un système d'insolation par projection microlithographique, la source de lumière EUV possédant une source d'électrons (110) destinée à générer un faisceau d'électrons, une unité d'accélération (120) destinée à accélérer ce faisceau d'électrons ainsi qu'un arrangement ondulateur (100) destiné à générer de la lumière EUV par déviation du faisceau d'électrons, cet arrangement ondulateur (100) possédant :

• un premier ondulateur (101) destiné à générer de la lumière EUV avec un premier état de polarisation ; et
• au moins un deuxième ondulateur (102) destiné à générer de la lumière EUV avec un deuxième état de polarisation, le deuxième état de polarisation étant différent du premier état de polarisation ;
• le deuxième ondulateur (102) étant disposé après le premier ondulateur (101) le long du sens de propagation du faisceau d'électrons ; et
• l'arrangement ondulateur (100) étant configuré de telle sorte que celui-ci possède un premier mode de fonctionnement dans lequel le premier ondulateur (101) se trouve en saturation du point de vue de la génération de lumière EUV,

**caractérisée en ce que** l'arrangement ondulateur (100) possède au moins un deuxième mode de fonctionnement dans lequel le premier ondulateur (101) ne se trouve pas en saturation du point de vue de la génération de lumière EUV.

2. Source de lumière EUV selon la revendication 1, **caractérisée en ce que** l'arrangement ondulateur (100) est configuré de telle sorte que, dans au moins un mode de fonctionnement, la génération de la lumière EUV s'effectue dans une part d'au moins 90 % par le deuxième ondulateur (102).

3. Source de lumière EUV selon la revendication 1, **caractérisée en ce que** l'arrangement ondulateur (100) est configuré de telle sorte que, dans au moins un mode de fonctionnement, la génération de la lumière EUV s'effectue dans une part d'au moins 90 % par le premier ondulateur (101).

4. Source de lumière EUV selon l'une des revendications 1 à 3, **caractérisée en ce que** l'arrangement ondulateur (100) est configuré de telle sorte que, dans au moins un mode de fonctionnement, la génération de la lumière EUV s'effectue dans une part d'au moins 40 % par le premier ondulateur (101) et aussi dans une part d'au moins 40 % par le deuxième ondulateur (102).

5. Source de lumière EUV selon l'une des revendications précédentes, **caractérisée en ce que** l'état de polarisation de la lumière EUV générée par l'arrangement ondulateur (100) est réglable de manière variable en modifiant le faisceau d'électrons avant son entrée dans l'arrangement ondulateur (100).

6. Source de lumière EUV selon l'une des revendications précédentes, **caractérisée en ce que** l'état de polarisation de la lumière EUV générée par l'arrangement ondulateur (100) est réglable de manière variable en modifiant la longueur de gain du faisceau d'électrons avant son entrée dans l'arrangement ondulateur (100).

7. Source de lumière EUV selon l'une des revendications précédentes, **caractérisée en ce que** celle-ci possède une pluralité d'aimants quadripôles pouvant être chargés par un courant électrique et servant à concentrer le faisceau d'électrons, la permutation entre le premier mode de fonctionnement et le deuxième mode de fonctionnement s'effectuant au moins partiellement en faisant varier le courant électrique dans au moins l'un de ces aimants quadripôles.

8. Source de lumière EUV selon l'une des revendications précédentes, **caractérisée en ce que** le premier état de polarisation et le deuxième état de polarisation sont mutuellement orthogonaux.

**9.** Système d'insolation par projection microlithographique comprenant un système d'éclairage (503) et un objectif de projection (506), **caractérisé en ce que** celui-ci possède une source de lumière EUV selon l'une des revendications précédentes.

**10.** Système d'insolation par projection microlithographique comprenant une source de lumière EUV, un système d'éclairage (503) et un objectif de projection (506), la source de lumière EUV possédant une source d'électrons (110, 810) destinée à générer un faisceau d'électrons, une unité d'accélération (120, 820) destinée à accélérer ce faisceau d'électrons ainsi qu'un arrangement ondulateur (100, 800) destiné à générer de la lumière EUV par déviation du faisceau d'électrons,

> • cet arrangement ondulateur (100, 800) possédant un premier ondulateur (101, 801) destiné à générer de la lumière EUV avec un premier état de polarisation et au moins un deuxième ondulateur (102, 802) destiné à générer de la lumière EUV avec un deuxième état de polarisation, le deuxième état de polarisation étant différent du premier état de polarisation ;
> • lors du fonctionnement du système d'insolation par projection, la lumière EUV générée par le premier ondulateur (101, 801) et la lumière EUV générée par le deuxième ondulateur (102, 802) étant respectivement injectées dans le dispositif d'éclairage (503) ; et
> • la part relative respective de laquelle l'énergie du faisceau d'électrons est convertie en la lumière EUV générée par le premier ondulateur (101, 801) ou en la lumière EUV générée par le deuxième ondulateur (102, 802) étant réglable de manière variable.

**11.** Système d'insolation par projection microlithographique selon la revendication 10, **caractérisé en ce que** le réglage variable de la part relative respective de laquelle l'énergie du faisceau d'électrons est convertie en la lumière EUV générée par le premier ondulateur (101, 801) ou en la lumière EUV générée par le deuxième ondulateur (102, 802) peut être effectué en modifiant le faisceau d'électrons avant son entrée dans l'arrangement ondulateur (100, 800).

**12.** Procédé pour faire fonctionner une source de lumière EUV pour un dispositif d'éclairage d'un système d'insolation par projection microlithographique, la source de lumière EUV possédant une source d'électrons (110) destinée à générer un faisceau d'électrons, une unité d'accélération (120) destinée à accélérer ce faisceau d'électrons ainsi qu'un arrangement ondulateur (100) destiné à générer de la lumière EUV par déviation du faisceau d'électrons, cet arrangement ondulateur (100) possédant :

> • un premier ondulateur (101) destiné à générer de la lumière EUV avec un premier état de polarisation ; et
> • au moins un deuxième ondulateur (102) destiné à générer de la lumière EUV avec un deuxième état de polarisation, le deuxième état de polarisation étant différent du premier état de polarisation ;
> • le deuxième ondulateur (102) étant disposé après le premier ondulateur (101) le long du sens de propagation du faisceau d'électrons ;
> • lors du fonctionnement de l'arrangement ondulateur (100), une permutation s'effectuant entre un premier mode de fonctionnement, dans lequel le premier ondulateur (101) se trouve en saturation du point de vue de la génération de lumière EUV, et au moins un deuxième mode de fonctionnement, dans lequel le premier ondulateur (101) ne se trouve pas en saturation du point de vue de la génération de lumière EUV.

**13.** Procédé selon la revendication 12, **caractérisé en ce que** la permutation entre le premier mode de fonctionnement et le deuxième mode de fonctionnement s'effectue en modifiant le faisceau d'électrons avant son entrée dans l'arrangement ondulateur (100).

**14.** Procédé pour faire fonctionner une source de lumière EUV pour un système d'éclairage d'un système d'insolation par projection microlithographique, la source de lumière EUV possédant une source d'électrons (110) destinée à générer un faisceau d'électrons, une unité d'accélération (120) destinée à accélérer ce faisceau d'électrons ainsi qu'un arrangement ondulateur (100) destiné à générer de la lumière EUV par déviation du faisceau d'électrons,

> • cet arrangement ondulateur (100, 800) possédant un premier ondulateur (101, 801) destiné à générer de la lumière EUV avec un premier état de polarisation et au moins un deuxième ondulateur (102, 802) destiné à générer de la lumière EUV avec un deuxième état de polarisation, le deuxième état de polarisation étant différent du premier état de polarisation ;
> • lors du fonctionnement du système d'insolation par projection, la lumière EUV générée par le premier ondulateur (101, 801) et la lumière EUV générée par le deuxième ondulateur (102, 802) étant respectivement injectées dans le dispositif d'éclairage (503) ; et
> • la part relative respective de laquelle l'énergie du faisceau d'électrons est convertie en la lumière EUV générée par le premier ondulateur (101, 801) ou en la lumière EUV générée par le deuxième ondulateur (102, 802) étant réglée de manière variable.

**15.** Procédé de fabrication microlithographique de composants microstructurés, comprenant les étapes suivantes :

> • fourniture d'un substrat sur lequel est appliquée au moins partiellement une couche de matériau photosensible ;
> • fourniture d'un masque (505) qui présente des structures à représenter ;
> • fourniture d'un système d'insolation par projection microlithographique selon l'une des revendications 9 à 11 ; et
> • projection d'au moins une partie du masque (505) sur une zone de la couche à l'aide du système d'insolation par projection.

**Fig. 1**

EP 3 123 246 B1

## Fig. 2

EP 3 123 246 B1

## Fig. 3

101  102

| I | Beginn ... Ende |
| II | Beginn ... Ende |
| III | Beginn ... Ende | Beginn ... Ende |

## Fig. 4

**Fig. 5**

501a

503

501b

502

10

200

504

505

506

507

y

z

EP 3 123 246 B1

EP 3 123 246 B1

# Fig. 6

# Fig. 7

## a)

710    705       720    705     S1

701      702

700

705    S2

## b)

710    705       720    705     S1

701      702

700

705    S2

EP 3 123 246 B1

**Fig. 8**

EP 3 123 246 B1

**IN DER BESCHREIBUNG AUFGEFÜHRTE DOKUMENTE**

**In der Beschreibung aufgeführte Patentdokumente**

- DE 102014205579
- DE 102008002749 A1
- US 20080192225 A1
- WO 2006111319 A2
- US 6999172 B2
- US 20070152171 A1


**In der Beschreibung aufgeführte Nicht-Patentliteratur**

- **GENG et al.** *Nuclear Instruments and Methods A,* 2010, vol. 622, 276-280
- **NEWNAM.** *Optical Engineering,* 1991, vol. 30, 1100-1108
- **Y. SOKOL ; G. N. KULIPANOV ; A. N. MATVEENKO ; O. A. SHEVCHENKO ; N. A. VINOKUROV.** Compact 13.5-nm free-electron laser for extreme ultraviolet lithography. *Phys. Rev. Spec. Top.,* 2011, vol. 14, 040702
- Ultraviolet and Soft X-Ray Free-Electron Lasers: Introduction to Physical Principles, Experimental Results, Technological Challenges. **P. SCHMÜSER et al.** STMP 229. Springer